# EUROPÄISCHE PATENTSCHRIFT

(11) **EP 1 525 618 B1**
(45) Veröffentlichungstag und Bekanntmachung des Hinweises auf die Patenterteilung: **15.08.2012**
(21) Anmeldenummer: 03740070.2
(22) Anmeldetag: 10.06.2003
(51) Int. Cl.: H01S 5/40, H01L 23/473

(54) **HALBLEITERVORRICHTUNG MIT KUEHLELEMENT**
SEMICONDUCTOR DEVICE WITH A COOLING ELEMENT
DISPOSITIF A SEMI-CONDUCTEUR POURVU D'UN ELEMENT DE REFROIDISSEMENT

(30) Priorität: 30.07.2002 DE 10234704
(43) Veröffentlichungstag der Anmeldung: 27.04.2005
(73) Patentinhaber: OSRAM Opto Semiconductors GmbH, 93055 Regensburg (DE)
(72) Erfinder: GROETSCH, Stefan, 93077 Lengfeld / Bad Abbach (DE)
(74) Vertreter: Epping - Hermann - Fischer
(86) Internationale Anmeldenummer: PCT/DE2003/001906
(87) Internationale Veröffentlichungsnummer: WO 2004/017476

(56) Entgegenhaltungen:
- EP-A- 0 509 825
- EP-A- 0 771 604
- DE-A1- 4 315 580
- DE-A1- 19 706 276
- US-A- 5 812 570
- US-A- 6 383 278
- US-A1- 2002 063 329
- US-A1- 2002 162 338
- KERNS J A ET AL: "DYMALLOY: A COMPOSITE SUBSTRATE FOR HIGH POWER DENSITY ELECTRONIC COMPONENTS" INTERNATIONAL JOURNAL OF MICROCIRCUITS AND ELECTRONIC PACKAGING, INTERNATIONAL MICROELECTRONICS & PACKAGING SOCIETY, US, Bd. 19, Nr. 3, 1. Juli 1996 (1996-07-01), Seiten 206-211, XP000639483 ISSN: 1063-1674
- W.B. JOHNSON ET AL.: JOURNAL OF MATERIALS RESEARCH, Bd. 8, Nr. 5, Mai 1993 (1993-05), Seiten 1169-1173, XP002304359
- INAL O T ET AL: "Fabrication and characterization of diamond/copper composites for thermal management substrate applications" MATERIALS SCIENCE AND ENGINEERING B, ELSEVIER SEQUOIA, LAUSANNE, CH, Bd. 41, Nr. 2, 1. November 1996 (1996-11-01), Seiten 261-266, XP004049585 ISSN: 0921-5107
- KREUTZ E W ET AL: "Simulation of micro-channel heat sinks for optoelectronic microsystems", MICROELECTRONICS JOURNAL, MACKINTOSH PUBLICATIONS LTD. LUTON, GB LNKD- DOI:10.1016/S0026-2692(00)00060-4, vol. 31, no. 9-10, 1 October 2000 (2000-10-01), pages 787-790, XP004218841, ISSN: 0026-2692
- V. KRAUSE ET AL.: '"Microchannels coolers for high power laser diodes..."' PROCEEDINGS OF THE SPIE: LASER DIODE TECHNOLOGY AND APPLICATIONS VI Bd. 2148, Seiten 351 - 358

## Beschreibung

Die Erfindung betrifft eine Halbleitervorrichtung mit einem Halbleiterbauelement, insbesondere einer Laserdiode oder einem Laserbarren, das auf einem Kühlelement angeordnet ist, wobei das Kühlelement in seinem Inneren einen Kühlkanal zum Führen eines Kühlmittels enthält, welcher in zumindest einem Bereich Mikrostrukturen für eine effektive Wärmeankopplung an das Kühlmittel aufweist.

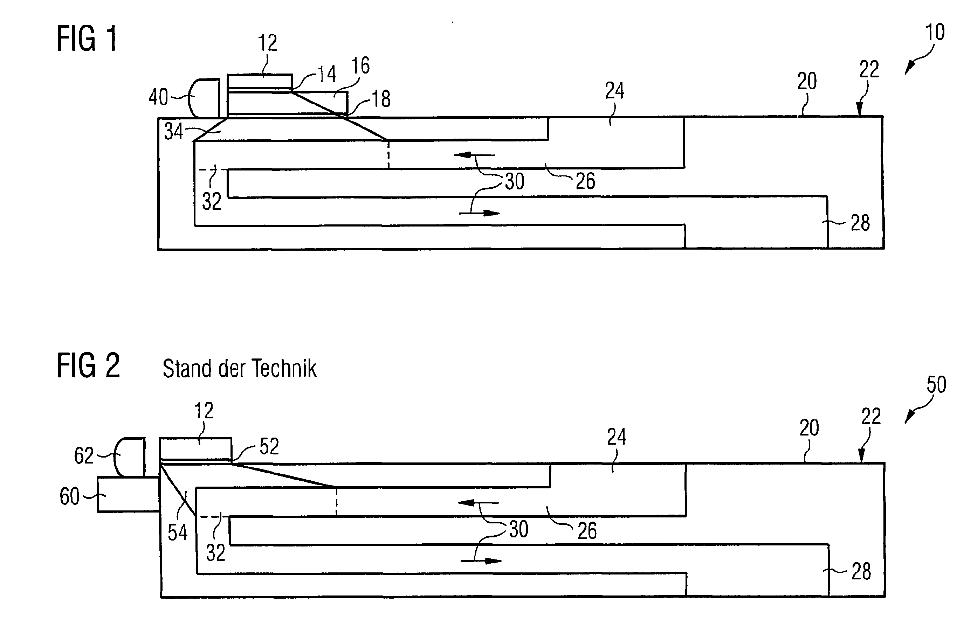

Eine bekannte derartige Halbleitervorrichtung ist beispielsweise in der Patentschrift DE 195 06 093 C2 gezeigt und beschrieben. Eine schematische Darstellung einer solchen bekannten Halbleitervorrichtungen ist in der Fig. 2 dargestellt. Ein Mikrokühler 20 wird dabei durch das Zusammenbonden mehrerer, durch Ätzen strukturierter Kupferfolien hergestellt. Die einzelnen Lagen bilden im Zusammenspiel einen Kühlwassereinlaß 24, einen Kühlkanal 26, der das Kühlwasser zu dem Bereich des Mikrokühlers 20, auf dem ein Leistungs-Laserbarren 12 montiert ist, führt, und einen Kühlwasserauslaß 28. Das Kühlmittel strömt entlang der Pfeile 30 vom Einlaß 24 zum Auslaß 28. In zumindest einem Bereich 32 sind Mikrostrukturen, zum Beispiel schmale Kanäle verwirklicht. In diesem Bereich erfolgt durch eine turbulente Strömung des Kühlwassers ein besonders effektiver Wärmeaustausch.

Der Laserbarren 12 ist mit einem Weichlot 52, beispielsweise Indium, an der vorderen Kante des Mikrokühlers angelötet. Die direkte Montage des Barrens 12 auf dem Kupferblock 20 ermöglicht dabei einen verbesserten Wärmeübergang vom Laserbarren zum Kühler.

Nachteilig für die Wärmeanbindung an das Kühlwasser ist allerdings die Tatsache, daß direkt unter dem Laserbarren 12 aufgrund der Abdichtung kein mikrostrukturierter Bereich liegen kann. Es ergibt sich somit ein Wärmeflußbereich 54, wie in Fig. 2 dargestellt.

Bei Temperaturwechselbelastungen, wie etwa beim Abkühlen nach dem Lötschritt oder dem Ein- und Ausschalten des Laserbarrens können beispielsweise bei Indium bereits bei Temperaturhüben von 5 °C bis 7 °C plastische Verformungen im Weichlot auftreten. Diese können zum teilweisen oder vollständigen Bruch der Verbindung führen. Eine teilweise oder vollständig unterbrochene Verbindung liefert eine deutlich verschlechterte Wärmeabführung und eine unerwünschte inhomogene Stromverteilung in dem Laserbarren.

Aus der Druckschrift DE 43 15 580 A1 ist eine Anordnung aus Laserdioden bekannt, bei der ein Laserdiodenbarren mit einem elastischen Lotmaterial auf einer Mikrokanalwärmesenke befestigt ist. Zur Montage einer Mikrooptik weist die Oberseite der Mikrokanalwärmesenke einen herabgesetzten Bereich auf.

In der Druckschrift US 5,812,570 ist eine Laserdiodenkomponente beschrieben, die über eine Verbindungsplatte mit einem Kühlkörper mit einem Kühlmittel verbunden ist. Der thermische Ausdehnungskoeffizient der Verbindungsplatte ist an den thermischen Ausdehnungskoeffizienten des Halbleitermaterials angepaßt.

In der Druckschrift DE 197 06 276 A1 wird eine Halbleiterlaser-Vorrichtung angegeben, bei der ein Halbleiterlaserchip über ein Zwischenträgerteil mit einem Grundkörperteil verbunden ist. Auf dem Grundkörperteil ist weiterhin eine Zylinderlinse angeordnet.

Der vorliegenden Erfindung liegt die Aufgabe zugrunde, bei einer Vorrichtung der eingangs genannten Art die thermische und mechanische Ankopplung des Halbleiterbauelements auf dem Mikrokühler zu verbessern. Insbesondere soll sowohl eine hohe Wärmeableitungsleistung als auch eine hohe mechanische Stabilität der Anordnung gewährleistet sein.

Diese Aufgabe wird durch die Halbleitervorrichtung nach Anspruch 1 gelöst. Vorteilhafte Weiterbildungen der Halbleitervorrichtung ergeben sich aus den Unteransprüchen 2 bis 10.

Obwohl in Zusammenhang mit Leistungs-Laserbarren diskutiert, versteht sich für den Fachmann, daß sich eine Reihe der im Folgenden beschriebenen Vorteile der erfindungsgemäßen Lösung nicht nur bei Leistungs-Laserbarren ergeben. Vielmehr kann die Erfindung auch bei anderen Halbleitervorrichtungen mit Vorteil eingesetzt werden, bei denen ein Halbleiterbauelement auf einem Mikrokühler mit einem sich vom Halbleitermaterial unterscheidenden thermischen Ausdehnungskoeffizienten angeordnet ist, und die im Betrieb wesentlichen Temperaturänderungen ausgesetzt sind.

Dies trifft außer auf die genannten Leistungs-Laserbarren beispielsweise auch auf Leistungs-Transistoren und Leistungs-Leuchtdioden zu, oder beispielsweise auch auf Halbleitervorrichtungen, die im Kfz-Bereich, in Flugzeugen oder dergleichen zum Einsatz kommen und dort erheblichen Außentemperaturschwankungen ausgesetzt sind.

Erfindungsgemäß ist bei einer Halbleitervorrichtung der eingangs genannten Art vorgesehen, daß zwischen dem Halbleiterbauelement und dem Kühlelement ein Zwischenträger angeordnet ist, der im wesentlichen vollständig mit dem die Mikrostrukturen aufweisenden Bereich des Kühlkanals auf dem Kühlelement überlappt und der für die Kompensation von aufgrund von Temperaturdifferenzen zwischen dem Halbleiterbauelement und dem Kühlelement auftretenden mechanischen Spannungen eingerichtet und ausgelegt ist.

Der Zwischenträger überlappt dann "im wesentlichen vollständig" mit den Mikrostrukturen aufweisenden Bereich, sobald der Bereich, auf dem das Halbleiterbauelement angeordnet ist, überlappt. Unerheblich ist diesbezüglich, ob irgendwelche elektrische Anschlußbereiche oder ähnliches über den Überlappungsbereich hinausragen.

Die Erfindung beruht also auf dem Gedanken, die Wärme vom Halbleiterbauelement auf kürzestmöglichem Weg zum Kühlmittel zu führen und gleichzeitig die mechanische Stabilität der Verbindung zwischen Halbleiterbauelement und Kühlelement mittels eines unterschiedliche Ausdehnungen kompensierenden Zwischenträgers zu gewährleisten.

Mit Vorteil ist bei der erfindungsgemäßen Halbleitervorrichtung vorgesehen, daß der thermischen Ausdehnungskoeffizient des Zwischenträgers an den thermische Ausdehnungskoeffizient des Halbleiterbauelements angepaßt ist, und der Zwischenträger einen derart hohen Elastizitätsmodul aufweist, so daß der Zwischenträger bei Temperaturdifferenzen zwischen dem Halbleiterbauelement und dem Kühlelement auftretende mechanische Spannungen im wesentlichen im elastischen Dehnungsbereich kompensiert.

Der Zwischenträger gleicht damit die unterschiedliche thermische Ausdehnung von Halbleiterbauelement und Kühlelement durch vollständig reversible Dehnung aus. Eine mechanische Belastung des Halbleiterbauelements wird daher weitestgehend vermieden.

Bevorzugt weist der Zwischenträger eine höhere Wärmeleitfähigkeit als Kupfer, insbesondere eine ca. 1,5 fach höhere, vorzugsweise eine dreifach höhere Wärmeleitfähigkeit als Kupfer auf.

Das Halbleiterbauelement ist in einer bevorzugten Ausgestaltung der Erfindung mit einem Hartlot mit dem Zwischenträger verbunden. Da erfindungsgemäß der Zwischenträger die unterschiedliche thermische Ausdehnung aufnimmt, muß diese Funktion nicht mehr, wie bei den Gestaltungen nach dem Stand der Technik, von einem plastisch verformbaren Weichlot übernommen werden. Dies schafft die Freiheit, für die Verbindung von Bauelement und Zwischenträger statt dessen ein hochtemperaturfestes und zykelstabiles Hartlot einzusetzen.

Bei einer vorteilhaften Weiterbildung der erfindungsgemäßen Vorrichtung ist aus den gleichen Gründen der Zwischenträger ebenfalls mittels eines Hartlotes mit dem Kühlelement verbunden.

Besonders bevorzugt ist der Zwischenträger sowohl mit dem Kühlelement als auch mit dem Halbleiterbauelement über ein Hartlot oder ein im Vergleich zum Indium signifikant höherschmelzendes Lot verbunden.

Als Hartlotmaterialien kommen dabei vorzugsweise AuSn, AuGe oder AuSi in Betracht. Höherschmelzende Lote im obigen Sinne sind beispielsweise SnAgSb, SnCu oder SnSb. Im vorliegenden Zusammenhang ist gegenwärtig die Verwendung von AuSn als Hartlot bevorzugt.

Gemäß einer bevorzugten Ausgestaltung der erfindungsgemäßen Halbleitervorrichtung ist vorgesehen, daß der Zwischenträger aus Molybdän, Wolfram, einer Kupfer-Molybdän-Legierung oder einer Kupfer-Wolfram-Legierung gefertigt ist. Der Kupferanteil der Kupfer-Molybdän- bzw. der Kupfer-Wolfram Legierung liegt dabei zweckmäßig zwischen etwa 10% und etwa 20%. Diese Materialien weisen einen hohen Elastizitätsmodul von mehr als 250 GPa oder sogar von mehr als 300 GPa auf. Darüber hinaus bieten diese Materialien eine hohe Fließspannung eine hohe Temperaturbeständigkeit.

Ein Zwischenträger läßt sich aus diesen Materialien sowohl als Folie, aber auch als Sputter-, Aufdampf- oder Galvanikschicht auf dem Kühlelement herstellen. Es versteht sich, daß sich in den letztgenannten Fällen die Anbindung des Zwischenträgers an den Kühlkörper durch Hartlöten erübrigt.

Bei einer anderen bevorzugten Ausgestaltung der Erfindung weist der Zwischenträger ein Diamant-Komposit-Material, insbesondere ein Diamant-Metallmatrix-Material auf. Bevorzugt enthält ein solcher Zwischenträger mindestens eine der Materialkombinationen Diamant-Kupfer, Diamant-Kobalt und Diamant-Aluminium. Diese Materialien bieten mit bis zu 600 W/mK höhere Wärmeleitfähigkeiten als Kupfer und gleichzeitig Ausdehnungskoeffizienten, die in etwa dem Halbleiterbauelement entsprechen. Beim Einsatz eines Kupfer-Diamant-Zwischenträgers enthält die Verbindungsschicht zum Halbleiterbauelement hin vorzugsweise AuSn und die Verbindungsschicht zum Kühlelement hin vorzugsweise SnAgSb.

Besonders bevorzugt ist die Anwendung des erfindungsgemäßen Aufbaus bei Vorrichtungen mit Leistungs-Halbleiter-Laserdiodenbarren auf Basis von AlGaAs.

Bei der erfindungsgemäßen Halbleitervorrichtung ist auf ein und derselben Außenfläche des Kühlelements eine Laserdiode und eine Strahlkollimationseinrichtung, bevorzugt eine Mikrolinse, angeordnet. Die Strahlkollimationseinrichtung kollimiert die Strahldivergenz der Laserdiode. Ohne die Strahlkollimationseinrichtung kann der Zwischenträger maximal um tan(Strahldivergenz) nach hinten versetzt sein ohne dass eine Abschattung durch das Kühlelement hervorgerufen wird. Das reicht in der Regel nicht, um den Barren samt Zwischenträger hinreichend zentral auf die Mikrokühlstrukturen zu setzen.

Eine Mikrolinse zur Strahlkollimation wird oft auch in herkömmlichen Vorrichtungen nach dem Stand der Technik eingesetzt. Wie in der Fig. 2 dargestellt, wird die Mikrolinse 62 wegen der herkömmlichen Anordnung des Laserbarrens 12 an der Kante des Mikrokühlers mit einem Hilfsträgerteil 60 am Kühler 20 befestigt.

Demgegenüber ist bei der Vorrichtung gemäß der Erfindung vorteilhafterweise kein enstprechendes zusätzliches Anbauteil erforderlich.

Bei der erfindungsgemäßen Halbleitervorrichtung ist vorgesehen, daß das Kühlelement mehrere übereinander gestapelte und flächig miteinander verbundene Schichten aufweist, von denen ein Teil strukturiert ist, um im Inneren des Kühlelements den Kühlkanal zum Führen des Kühlmittels zu bilden.

Diese Schichten des Kühlelements sind vorzugsweise aus Kupferfolien gebildet, die mittels Ätzen strukturiert sind.

Weitere Vorteile, vorteilhafte Ausgestaltungen, Merkmale und Details der Erfindung ergeben sich aus den abhängigen Ansprüchen, der nachfolgenden Beschreibung eines Ausführungsbeispieles mit den zugehörigen Zeichnungen.

In den Zeichnungen sind jeweils nur die für das Verständnis der Erfindung wesentlichen Elemente dargestellt.
Dabei zeigen
- Figur 1: eine schematische Darstellung einer Schnittansicht des Ausführungsbeispiels; und
- Figur 2: eine schematische Darstellung einer Schnittansicht einer Halbleitervorrichtung nach dem Stand der Technik (weiter oben näher erläutert).

Die in Figur 1 im Schnitt dargestellte Halbleitervorrichtung 10 umfaßt einen Leistungs-Laserdiodenbarren 12, der auf einen Mikrokühler 20 mit einem Kühlwassereinlaß 24 an seiner Oberseite, einem Kühlkanal 26 in seinem Innern und einem Kühlwasserauslaß 28 an seiner Unterseite aufgelötet ist. Die Strömungsrichtung des Kühlmittels im Mikrokühler 20 ist durch Pfeile 30 angegeben.

Der Kühlkanal 26 weist in einem Bereich 32 unterhalb des Leistungs-Laserdiodenbarrens 12 Mikrostrukturen auf, beispiels weise eine Mehrzahl von Kanälen mit jeweils 0,3 mm Breite und Höhe. Solche Mikrostrukturen rufen Turbulenzen im strömenden Kühlmittel hervor, wodurch der Wärmeaustausch zwischen Kühlmittel und Mikrokühler sehr effektiv gestaltet wird.

Die Länge des mikrostrukturierten Bereichs 32 im Kühlkanal 26 ist zumindest gleich der Länge des Leistungs-Laserdiodenbarrens 12, der zumindest in dieser Erstreckungsrichtung mit dem mikrostrukturierten Bereich 32 vollständig überlappt. Vorzugsweise ist, wie in Figur 1 dargestellt, die Länge des mikrostrukturierten Bereiches 32 größer als die des Leistungs-Laserdiodenbarrens 12, so dass sich der Querschnitt des Bereichs, in dem der Wärmefluß vom Leistungs-Laserdiodenbarren 12 zum mikrostrukturierten Bereich 32 hin stattfindet, vergrößert.

Weiterhin ist der mikrostrukturierte Bereich 32 auch genau so breit oder breiter als der Leistungs-Laserdiodenbarren 12. Zwischen dem Leistungs-Laserdiodenbarren 12 und dem Mikrokühler 20 ist ein Zwischenträger 16 angeordnet, der über dem mikrostrukturierten Bereich 32 auf die Oberfläche des Mikrokühlers 20 aufgelötet ist und mit diesem vollständig überlappt.

Der Zwischenträger 16 besteht beispielsweise aus einer Kupfer-Wolfram-Legierung mit einem Kupferanteil von 15% und hat eine Dicke von beispielsweise 250 µm.

Die Verbindung zwischen dem Leistungs-Laserdiodenbarren 12 und dem Zwischenträger 16 und die Verbindung zwischen dem Zwischenträger 16 und der Oberfläche 22 des Mikrokühlers 20 ist mit AuSn ausgeführt, einem Lot, das im wesentlichen keine plastische Eigenschaften aufweist. Diese Hartlotschichten sind in der Fig. 1 mit den Bezugszeichen 14 bzw. 18 gekennzeichnet.

Aufgrund seines hohen Elastizitätsmoduls nimmt der Zwischenträger 16 mechanische Spannungen, die beispielsweise aufgrund einer betriebsbedingten Erwärmung und einer unterschiedlichen thermischen Ausdehnung der Materialien des Leistungs-Laserdiodenbarrens 12 und des Mikrokühlers (Kupfer) 20 entstehen, im elastischen Dehnungsbereich auf, so daß die Gefahr einer Schädigung der Hartlotschichten 14,18 und/oder des Leistungs-Laserdiodenbarrens 12 weitestgehend vermindert ist.

Verglichen mit einer reinen Indium-Weichlot-Verbindung zwischen Leistungs-Laserdiodenbarren und Mikrokühler, wie sie aus dem Stand der Technik bekannt ist, weist der Zwischenträger 16 zwar eine geringere Wärmeleitfähigkeit auf. Diese reduzierte Wärmeleitfähigkeit wird jedoch durch die wesentlich günstigere Wärmeanbindung des Leistungs-Laserdiodenbarrens 12 an den mikrostrukturierten Bereich 32 überkompensiert, so daß insgesamt gegenüber der in der Fig. 2 gezeigten herkömmlichen Gestaltung ein verbesserter Wärmefluß zwischen Leistungs-Laserdiodenbarren und Kühlwasser erreicht wird.

Der Wärmeübergangswiderstand Rₜₕ für einen 10 mm langen Leistungs-Laserdiodenbarren liegt bei der erfindungsgemäßen Gestaltung nach der Fig. 1 um bis 40% unter den mit herkömmlichen Gestaltungen erreichten Werten.

Auf der Oberfläche des Mikrokühlers 20, auf dem der Leistungs-Laserdiodenbarren 12 montiert ist, befindet sich, wie in Fig. 1 dargestellt, eine Mikrolinse 40 zur Strahlkollimation. Die Oberfläche 22 bietet dazu vorteilhafterweise in unmittelbarer Nähe zum Leistungs-Laserdiodenbarren eine geeignete Montagefläche. Hilfsteile oder Anbauten an den Mikrokühler, wie sie bei bekannten Vorrichtungen notwendig sind, sind bei einer Vorrichtung, die die vorangehend offenbarte technische Lehre benutzt, nicht erforderlich.

Die Erläuterung der Erfindung an Hand des Ausführungsbeispieles ist selbstverständlich nicht als Beschränkung der Erfindung auf dieses zu verstehen. Vielmehr sind die im vorstehenden allgemeinen Teil der Beschreibung, in der Zeichnung sowie in den Ansprüchen offenbarten Merkmale der Erfindung sowohl einzeln als auch in dem Fachmann als geeignet erscheinender Kombination für die Verwirklichung der Erfindung wesentlich. So ist beispielsweise an Stelle des im Ausführungsbeispiel beispielhaft angegebenen Zwischenträgers 16 aus einer Kupfer-Wolfram-Legierung, der vorzugsweise auf beiden Seiten mit je einem Hartlot 14, 18 mit dem Kühlelement 20 bzw. mit dem Halbleiterbauelement 12 verbunden ist, ein Zwischenträger 16 verwendbar, der, wie im allgemeinen Teil der Beschreibung angegeben, ein Diamant-Komposit-Material aufweist. Beim Einsatz eines Kupfer-Diamant-Zwischenträgers enthält die Verbindungsschicht 14 zum Halbleiterbauelement 12 hin vorzugsweise AuSn und die Verbindungsschicht 18 zum Kühlelement 20 hin vorzugsweise SnAgSb.

## Patentansprüche

1. Halbleitervorrichtung mit
- einem Leistungs-Laserdiodenbarren (12), der auf einem Kühlelement (20) angeordnet ist, wobei
- das Kühlelement (20) aus mehreren übereinander gestapelten und flächig miteinander verbundenen Schichten besteht, von denen ein Teil strukturiert ist, um im Inneren des Kühlelements (20) einen Kühlkanal (26) zum Führen eines Kühlmittels zu bilden, welcher in einem Bereich (32) Mikrostrukturen für einen effektiven Wärmeübergang zum Kühlmittel aufweist,
- die Länge des mikrostrukturierten Bereichs (32) zumindest gleich der oder größer als die Länge des Leistungs-Laserdiodenbarrens (12) und die Breite des mikrostrukturierten Bereichs (32) zumindest gleich der oder größer als die Breite des Leistungs-Laserdiodenbarrens (12) ist und der Leistungs-Laserdiodenbarren (12) im Wesentlichen vollständig mit dem die Mikrostrukturen aufweisenden Bereich (32) des Kühlkanals (26) überlappt und zwischen dem Leistungs-Laserdiodenbarren (12) und dem Kühlelement (20) ein Zwischenträger (16) angeordnet ist, der derart eingerichtet und ausgelegt ist, dass er aufgrund von unterschiedlichen thermischen Ausdehnungen von Leistungs-Laserdiodenbarren (12) und Kühlelement (20) auftretende mechanische Spannungen zwischen Leistungs-Laserdiodenbarren (12) und Kühlelement (20) kompensiert, und
- auf ein und derselben Oberfläche des Kühlelements (20) der Leistungs-Laserdiodenbarren (12) und eine Strahlkollimationseinrichtung (40) angeordnet sind.

2. Halbleitervorrichtung nach Anspruch 1,
**dadurch gekennzeichnet, dass** der Zwischenträger (16) einen derart hohen Elastizitätsmodul aufweist, dass er die mechanischen Spannungen im elastischen Dehnungsbereich kompensiert.

3. Halbleitervorrichtung nach Anspruch 1 oder 2,
**dadurch gekennzeichnet, dass**
der Zwischenträger (16) eine höhere Wärmeleitfähigkeit als Kupfer aufweist.

4. Halbleitervorrichtung nach einem der Ansprüche 1 bis 3,
**dadurch gekennzeichnet, dass** die Strahlkollimationseinrichtung (40) eine Mikrolinse zur Strahlkollimation ist.

5. Halbleitervorrichtung nach mindestens einem der vorangehenden Ansprüche,
**dadurch gekennzeichnet, daß**
der Leistungs-Laserdiodenbarren (12) mittels eines Hartlots (14) mit dem Zwischenträger (16) verbunden ist.

6. Halbleitervorrichtung nach mindestens einem der vorangehenden Ansprüche,
**dadurch gekennzeichnet, daß**
der Zwischenträger (16) mittels eines Hartlots (18) mit dem Kühlelement (20) verbunden ist.

7. Halbleitervorrichtung nach mindestens einem der Ansprüche 5 oder 6,
**dadurch gekennzeichnet, daß**
als Hartlot (14, 18) ein auf einem AuSn-Lot basierendes Lot verwendet ist.

8. Halbleitervorrichtung nach mindestens einem der vorangehenden Ansprüche,
**dadurch gekennzeichnet, daß**
der Zwischenträger (16) aus Molybdän, Wolfram, einer Kupfer-Molybdän-Legierung oder einer Kupfer-Wolfram-Legierung, bevorzugt mit einem Kupferanteil von etwa 10% bis etwa 20% gefertigt ist.

9. Halbleitervorrichtung nach mindestens einem der vorangehenden Ansprüche,
**dadurch gekennzeichnet, daß**
der Zwischenträger (16) ein Diamant-Komposit-Material, insbesondere ein Diamant-Metallmatrix-Material aufweist, das insbesondere mindestens eine der Materialkombinationen Diamant-Kupfer, Diamant-Kobalt und Diamant-Aluminium enthält.

10. Halbleitervorrichtung nach Anspruch 1,
**dadurch gekennzeichnet, daß**
die Schichten des Kühlelements (20) durch zumindest teilweise durch Ätzen strukturierte Kupferfolien gebildet sind.

## Claims

1. A semiconductor device having
- a power laser diode bar (12), which is arranged on a cooling element (20), wherein
- the cooling element (20) consists of a plurality of layers stacked on one another and joined together face to face, a proportion of said layers being patterned to form a cooling duct (26) inside the cooling element (20) for conveying a coolant, which duct comprises micropatterns in a region (32) for effective heat transfer to the coolant,
- the length of the micropatterned region (32) is at least equal to or greater than the length of the power laser diode bar (12) and the width of the micropatterned region (32) is at least equal to or greater than the width of the power laser diode bar (12) and
the power laser diode bar (12) overlaps substantially completely with the region (32) of the cooling duct (26) comprising the micropatterns and an intermediate carrier (16) is arranged between the power laser diode bar (12) and the cooling element (20), which intermediate carrier is designed and configured such that it compensates mechanical stresses between power laser diode bar (12) and cooling element (20) arising as a result of different thermal expansions of power laser diode bar (12) and cooling element (20), and
- the power laser diode bar (12) and a beam collimator (40) are arranged on one and the same surface of the cooling element (20).

2. A semiconductor device according to claim 1, **characterised in that** the intermediate carrier (16) exhibits a modulus of elasticity of such magnitude that it compensates the mechanical stresses in the elastic strain range.

3. A semiconductor device according to claim 1 or claim 2, **characterised in that** the intermediate carrier (16) exhibits a higher thermal conductivity than copper.

4. A semiconductor device according to any one of claims 1 to 3, **characterised in that** the beam collimator (40) is a microlens for beam collimation.

5. A semiconductor device according to at least one of the preceding claims, **characterised in that** the power laser diode bar (12) is joined to the intermediate carrier (16) by means of a hard solder (14).

6. A semiconductor device according to at least one of the preceding claims, **characterised in that** the intermediate carrier (16) is joined to the cooling element (20) by means of a hard solder (18).

7. A semiconductor device according to at least one of claims 5 or 6, **characterised in that** a solder based on an AuSn solder is used as the hard solder (14, 18).

8. A semiconductor device according to at least one of the preceding claims, **characterised in that** the intermediate carrier (16) is made of molybdenum, tungsten, a coppermolybdenum alloy or a copper-tungsten alloy, preferably with a copper content of approx. 10% to approx. 20%.

9. A semiconductor device according to at least one of the preceding claims, **characterised in that** the intermediate carrier (16) comprises a diamond composite material, in particular a diamond-metal matrix material, which in particular contains at least one of the material combinations diamond-copper, diamond-cobalt and diamond-aluminium.

10. A semiconductor device according to claim 1, **characterised in that** the layers of the cooling element (20) are formed at least in part by etching patterned copper foils.

## Revendications

1. Dispositif à semi-conducteur comprenant
- une barre de diodes laser de puissance (12) qui est disposée sur un élément de refroidissement (20),
- l'élément de refroidissement (20) étant constitué de plusieurs couches empilées les unes sur les autres et reliées entre elles de manière plane, dont une partie est structurée afin de former un canal de refroidissement (26) à l'intérieur de l'élément de refroidissement (20) pour le guidage d'un fluide de refroidissement lequel présente dans une zone (32) des microstructures pour une transmission de chaleur effective vers le fluide de refroidissement,
- la longueur de la zone micro-structurée (32) étant au moins égale ou supérieure à la longueur de la barre de diodes laser de puissance (12) et la largeur de la zone micro-structurée (32) étant au moins égale ou supérieure à la largeur de la barre de diodes laser de puissance (12) et la barre de diodes laser de puissance (12) chevauchant essentiellement complètement la zone (32) du canal de refroidissement (26) présentant les microstructures et un support intermédiaire (16) étant disposé entre la barre de diodes laser de puissance (12) et l'élément de refroidissement (20), lequel support intermédiaire est agencé et conçu de manière à ce qu'en raison de dilatations thermiques différentes de la barre de diodes laser de puissance (12) et de l'élément de refroidissement (20), il compense des tensions mécaniques se produisant entre la barre de diodes laser de puissance (12) et l'élément de refroidissement (20), et
- la barre de diodes laser de puissance (12) et un dispositif de collimation de faisceau (40) étant disposés sur une même surface de l'élément de refroidissement (20).

2. Dispositif à semi-conducteur selon la revendication 1,
**caractérisé en ce que**
le support intermédiaire (16) présente un module d'élasticité tellement élevé qu'il compense les tensions mécaniques dans la zone de dilatation élastique.

3. Dispositif à semi-conducteur selon la revendication 1 ou 2,
**caractérisé en ce que**
le support intermédiaire (16) présente une conductibilité thermique plus élevée que le cuivre.

4. Dispositif à semi-conducteur selon l'une quelconque des revendications 1 à 3,
**caractérisé en ce que**
le dispositif de collimation de faisceau (40) est une microlentille destinée à la collimation de faisceau.

5. Dispositif à semi-conducteur selon au moins l'une quelconque des revendications précédentes,
**caractérisé en ce que**
la barre de diodes laser de puissance (12) est reliée au support intermédiaire (16) au moyen d'une soudure forte (14).

6. Dispositif à semi-conducteur selon au moins l'une quelconque des revendications précédentes,
**caractérisé en ce que**
le support intermédiaire (16) est relié à l'élément de refroidissement (20) au moyen d'une soudure forte (18).

7. Dispositif à semi-conducteur selon au moins l'une quelconque des revendications 5 ou 6,
**caractérisé en ce qu'**
une soudure basée sur une soudure AuSn est utilisée en tant que soudure forte (14, 18).

8. Dispositif à semi-conducteur selon au moins l'une quelconque des revendications précédentes,
**caractérisé en ce que**
le support intermédiaire (16) est fabriqué en molybdène, wolfram, dans un alliage de cuivre-molybdène ou un alliage de cuivre-wolfram, de préférence avec une fraction de cuivre d'environ 10% à environ 20%.

9. Dispositif à semi-conducteur selon au moins l'une quelconque des revendications précédentes,
**caractérisé en ce que**
le support intermédiaire (16) présente un matériau composite du diamant, notamment un matériau à matrice métallique de diamant, qui contient notamment au moins une des combinaisons de matériaux diamant-cuivre, diamant-cobalt et diamant-aluminium.

10. Dispositif à semi-conducteur selon la revendication 1,
**caractérisé en ce que**
les couches de l'élément de refroidissement (20) sont formées au moins par gravure de feuilles de cuivre structurées.
